# EUROPÄISCHE PATENTSCHRIFT

(11) **EP 1 192 810 B1**
(45) Veröffentlichungstag und Bekanntmachung des Hinweises auf die Patenterteilung: **11.12.2002**
(21) Anmeldenummer: 00951233.6
(22) Anmeldetag: 21.06.2000
(51) Int. Cl.: H04Q 1/46, H04M 19/04, H04M 3/22

(54) **TONRUF-FREQUENZBESTIMMUNGSVORRICHTUNG UND -VERFAHREN**
DEVICE AND METHOD FOR DETERMINING TONE RINGING FREQUENCY
PROCEDE ET DISPOSITIF POUR DETERMINER LA SONNERIE ET LA FREQUENCE ACOUSTIQUE

(30) Priorität: 02.07.1999 DE 19930458
(43) Veröffentlichungstag der Anmeldung: 03.04.2002
(73) Patentinhaber: SIEMENS AKTIENGESELLSCHAFT, 80333 München (DE)
(72) Erfinder: MEISNER, Armin, D-64354 Rheinheim (DE)
(86) Internationale Anmeldenummer: DE0002021
(87) Internationale Veröffentlichungsnummer: WO01003445

(56) Entgegenhaltungen:
- EP-A- 0 566 928
- US-A- 5 007 000
- US-A- 5 023 906
- US-A- 5 901 219

## Beschreibung

### STAND DER TECHNIK

Die vorliegende Erfindung betrifft eine Tonruf-Frequenzbestimmungsvorrichtung sowie ein entsprechendes Tonruf-Frequenzbestiminungsverfahren.

Obwohl auf beliebige Tonrufsignalisierungen anwendbar, werden die vorliegende Erfindung sowie die ihr zugrundeliegende Problematik in bezug auf eine Tonruf-Signalisierung für ein Haustelefon erläutert.

Um eine fehlerfreie Signalisierung des Tonrufs zu gewährleisten, sind bestimmte Forderungen an eine Tonrufsignalisierung gestellt. Zum einen soll erst ab einer bestimmten Mindestaussteuerung (Pegelbedingung), zum andern nur auf Anregungen in einem festen Frequenzfenster (Frequenzbedingung), eine Signalisierung erfolgen.

Das Einhalten der Pegelbedingung wird in der Regel von der Hardware gewährleistet, die Einhaltung der Frequenzbedingung hingegen ist Aufgabe der Software. Ein Nichteinhalten einer oder beider Bedingungen führt zu einer falschen Rufsignalisierung (z.B. keine oder verspätete Signalisierung bei gültigem Rufsignal, Rufsignalisierung ohne Rufspannung, usw.).

Überlagerte Störungen der Rufwechselspannung haben einen großen Einfluß auf ein korrektes Arbeiten der Tonruf-Frequenzerkennung. Ein Erkennen von gestörten Frequenzen ist jedoch kein triviales Problem.

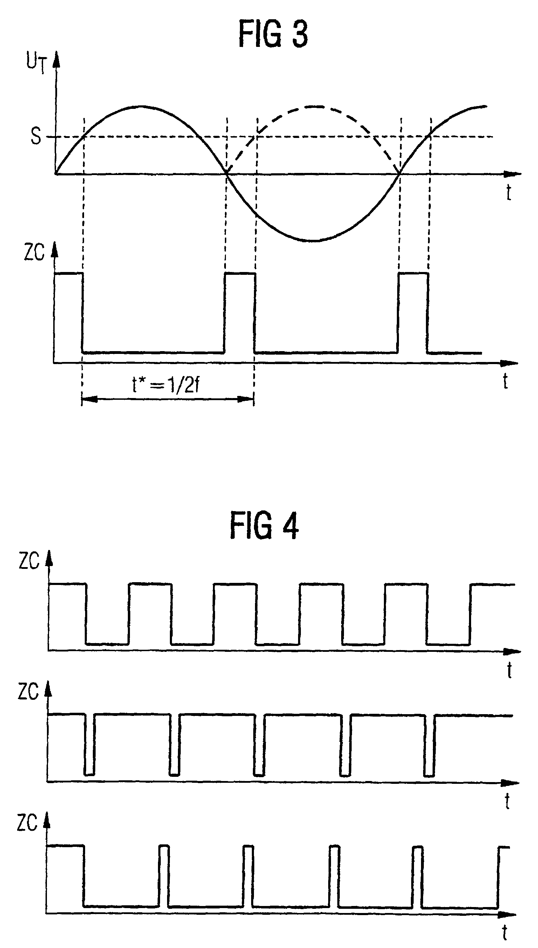

Fig. 3 zeigt eine Illustration zur Ableitung eines ZC-Signals (ZC = Zero Crossing) aus der erfaßten Tonrufspannung.

In Fig. 3 ist die Zeit t auf der x-Achse aufgetragen und die Tonrufspannung U_{T} bzw. das ZC-Signal ZC auf der y-Achse. Die Tonrufspannung U_{T} wird in diesem Fall als reine Sinus-Wechselspannung (durchgezogene Linie in Fig. 3 oben) angenommen.

Um eine Tonruf-Frequenzerkennung zu ermöglichen, wird die gleichgerichtete Tonrufspannung U_{T} (gestrichelte Linie in Fig. 3 oben) an einen nicht dargestellten Komparator angelegt. Der Ausgang des Komparators ist mit einem Prozessor verbunden, der das ZC-Signal verarbeitet.

Wie gezeigt, führt der Komparator einen Vergleich der gleichgerichteten Tonrufspannung U_{T} mit einer Schwelle S durch. Jedesmal wenn die gleichgerichtete Tonrufspannung U_{T} diese Schwelle ansteigend durchläuft, hat das ZC-Signal eine abfallende Flanke. Bei jedem darauffolgenden Nulldurchgang hat das ZC-Signal eine ansteigende Flanke. Hier ist also eine gewisse Hysterese eingebaut.

Die Frequenz f des Tonrufsignals ergibt sich in diesem einfachen Fall als t* = 1/2f, wobei t* der zeitliche Abstand zwischen zwei aufeinanderfolgenden ansteigenden bzw. abfallenden Flanken des ZC-Signals ist.

Fig. 4 zeigt eine Illustration eines ZC-Signals ohne Störung mit unterschiedlicher Amplitude des Tonrufsignals.

Wie Fig. 4 entnehmbar, ist je nach Lage der Komparatorschwelle S bzw. Signalaussteuerung des Tonrufsignals das Tastverhältnis des ZC-Signals höchst unterschiedlich.

Da jedoch, um die Periodendauer bzw. Frequenz f zu messen, üblicherweise immer auf die steigende oder fallende Flanke des ZC-Signals getriggert wird, ist eine Bestimmung der Frequenz f unabhängig vom Tastverhältnis des ZC-Signals möglich.

In realen Systemen muß damit gerechnet werden, daß das Tonrufsignal keine reine Sinusschwingung ist, sondern periodische und/oder aperiodische Überlagerungen aufweist. Diese Überlagerungen machen sich insbesondere dann bemerkbar, wenn die Amplitude der Störung größer als die Hysterese der ZC-Erkennungsschaltung ist.

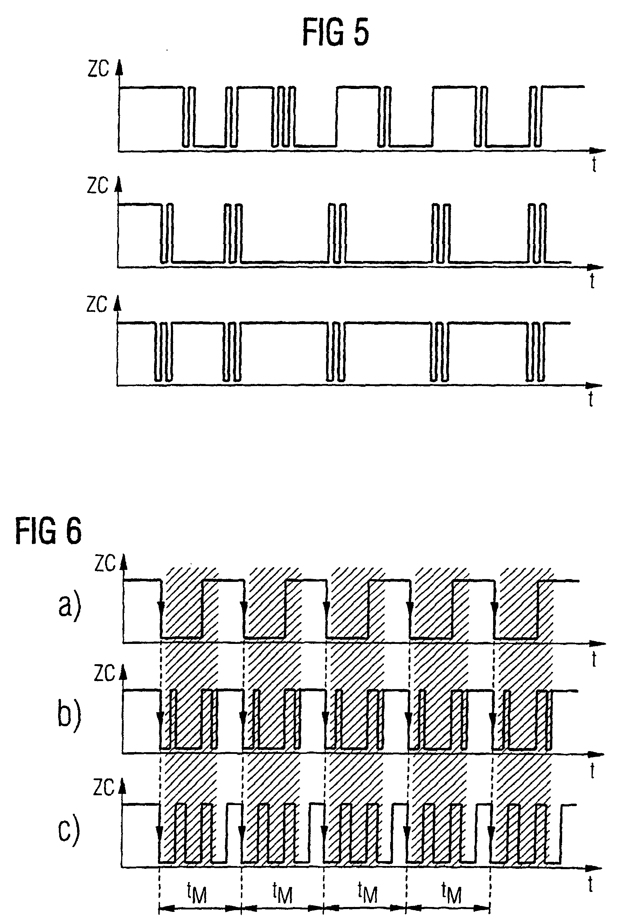

Ein Maß für die Unempfindlichkeit gegen solche Störungen ist die Fremdsignal-Störfestigkeit. Ein Überlagern von Störungen über das ZC-Signal führt zu Signalverläufen, die in Fig. 5 für ein gestörtes ZC-Signal mit unterschiedlichem Tastverhältnis gezeigt sind.

Eine möglichst schnelle Auswertung solcher gestörter ZC-Signale ist nicht trivial. Um die Grundschwingung zu ermitteln, müssen die Störungen ignoriert werden. Bei einem ungünstigen Tastverhältnis sind aber Störimpulse und Nutzsignal nicht mehr zu unterscheiden.

Bekannt sind Systeme, die Impulse oder Impulsgruppen ausblenden. Diese haben einerseits den Nachteil, daß zusätzliche Ressourcen (z.B. zweite Zeitbasis zum Ausblenden der Störungen) benötigt werden. Andererseits nehmen solche Systeme eigentlich eine Art Unterabtastung des ZC-Signals durch Ausblendung bestimmter Zeitbereiche vor. Ist dabei das ausgeblendete Zeitintervall, im Vergleich zu den zu messenden Zeiten, nicht mehr vernachlässigbar, treten Meßfehler auf.

Dies ist in Fig. 6 illustriert, welche Fehler beim Entstören des ZC-Signals aufzeigt, die durch einfaches Ausblenden der Störungen entstehen. Der ausgeblendete Zeitbereich ist dabei grau schraffiert. T_{M} bezeichnet das Meßintervall.

Im Fall a) von Fig. 6 liegt ein ZC-Signal ohne Störungen vor, die Tonruffrequenz f wird richtig bestimmt.

Im Fall b) von Fig. 6 liegt ein ZC-Signal mit Störungen vor, die Tonruffrequenz f wird richtig bestimmt.

Im Fall c) von Fig. 6 liegt ein ZC-Signal ohne Störungen vor, die Tonruffrequenz f wird nicht richtig bestimmt, da hier Teile des Nutzsignals fälschlicherweise ausgeblendet werden. Mit anderen Worten wird ein ungestörtes ungültiges Signal fälschlicherweise als gültig bestimmt.

Als nachteilhaft bei den obigen bekannten Ansätzen hat sich also die Tatsache herausgestellt, daß eine zuverlässige Entstörung nicht in allen Fällen möglich ist.

### VORTEILE DER ERFINDUNG

Das erfindungsgemäße Tonruf-Frequenzbestimmungsverfahren mit den Merkmalen des Anspruchs 1 und die entsprechende Tonruf-Frequenzbestimmungsvorrichtung gemäß Anspruch 5 weisen gegenüber den bekannten Lösungsansätzen den Vorteil auf, daß trotz hochfrequenter Störungen auf dem ZC-Signal eine zuverlässige Entstörung möglich ist im Gegensatz zu bekannten Ausblendverfahren.

Die der vorliegenden Erfindung zugrundeliegende Idee besteht darin, daß jedes Zeitintervall zwischen einer abfallenden und ansteigenden Flanke des ZC-Signals ausgewertet wird und anhand einer Grenzwertes ein Bewertungsstart- sowie Bewertungsstopp-Zeitpunkt bestimmt, wobei das so ermittelte Bewertungsintervall ein Maß für die gesuchte Frequenz ist.

In den abhängigen Ansprüchen finden sich vorteilhafte Weiterbildungen und Verbesserungen des betreffenden erfindungsgemäßen Gegenstandes.

Gemäß einer bevorzugten Weiterbildung wird ein Überwachungszeitfensters für die Frequenzbestimmung festgelegt und geschieht ein Abbrechen der Messung, falls die seit der Bewertungsstartzeit gemessene Zeit außerhalb des Überwachungszeitfensters liegt.

Gemäß einer weiteren bevorzugten Weiterbildung wird der Zeitdauer-Grenzwert als Konstante festgelegt.

Gemäß einer weiteren bevorzugten Weiterbildung wird für den Zeitdauer-Grenzwert ein größtmöglicher Wert festgelegt, mit dem der Versuch der Festlegung der Bewertungsstartzeit begonnen wird. Dieser Wert wird nach einem vorbestimmten Algorithmus verkleinert, wenn nach einer bestimmten Zeit keine Bewertungsstartzeit festlegbar ist.

### ZEICHNUNGEN

Ausführungsbeispiele der Erfindung sind in den Zeichnungen dargestellt und in der nachfolgenden Beschreibung näher erläutert.

Es zeigen:
- Fig. 1: eine Illustration einer Ausführungsform des erfindungsgemäßen Verfahrens in Anwendung auf ein gestörtes ZC-Signal mit unterschiedlichem Tastverhältnis;
- Fig. 2: ein Zustandsdiagramm der Ausführungsform des erfindungsgemäßen Verfahrens nach Fig. 1;
- Fig. 3: eine Illustration zur Ableitung eines ZC-Signals (ZC = Zero Crossing) aus der erfaßten Tonrufspannung;
- Fig. 4: eine Illustration eines ZC-Signals ohne Störung mit unterschiedlicher Amplitude des Tonrufsignals;
- Fig. 5: eine Illustration eines gestörten ZC-Signals mit unterschiedlichem Tastverhältnis; und
- Fig. 6: eine Illustration zum Problem, welche Fehler beim Entstören des ZC-Signals durch einfaches Ausblenden der Störungen entstehen.

### BESCHREIBUNG DER AUSFÜHRUNGSBEISPIELE

In den Figuren bezeichnen gleiche Bezugszeichen gleiche oder funktionsgleiche Bestandteile.

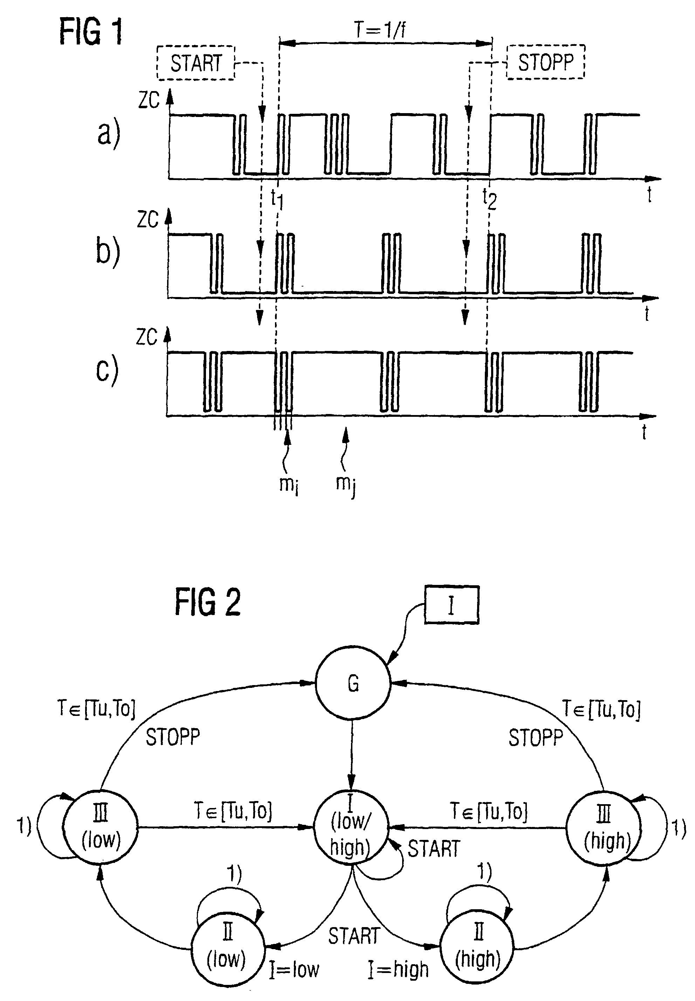

Fig. 1 zeigt eine Illustration einer Ausführungsform des erfindungsgemäßen Verfahrens in Anwendung auf ein gestörtes ZC-Signal mit unterschiedlichem Tastverhältnis.

Bei dieser Ausführungsform des erfindungsgemäßen Verfahrens werden zur Bestimmung der Grundwelle nicht einzelne Zeitbereiche ignoriert, sondern alle Teilereignisse berücksichtigt. Dabei wird davon ausgegangen, daß die Störungen, welche dem ZC-Signal überlagert sind, hochfrequenter als die zu bestimmende Frequenz f sind.

Mit anderen Worten findet ein ständiges Messen der jeweiligen Zeitdauer zwischen den benachbarten steigenden und fallenden Flanken des ZC-Signals statt. Aus diesen Teilereignissen wird dann die Frequenz der Grundschwingung abgeleitet. Die Ausführungsform setzt voraus, daß die Richtung der Flanke (fallend bzw. steigend) des ZC-Signals zum Erzeugen eines Interrupts sukzessive umgestellt werden kann.

Die Zeitdauern der einzelnen Teilmessungen mᵢ, mⱼ werden mit einem vorgegebenen bei diesem Beispiel konstanten Grenzwert t_{g} verglichen. Ist die Zeitdauer einer Teilmessung größer als der Grenzwert t_{g}, liegt die Startbedingung vor, d.h. es wird eine Bewertungsstartzeit t₁ festgelegt, wenn eine gemessene Zeitdauer größer oder gleich dem Zeitdauer-Grenzwert t_{g} ist, wobei die Bewertungsstartzeit (t₁) der Zeitpunkt der folgenden Flanke ist. Gleichzeitig wird die Phasenlage des ZC-Eingangssignals bestimmt werden ("0" = 1(ow) oder "1" = h(igh)). In Fig. 1a) und 1b) ist diese Phasenlage "0", und in Fig. 1c) ist sie "1".

Die Stoppbedingung ist der übernächste lange ZC-Signalzyklus mit der gleichen Phasenlage. Es wird also eine Bewertungsstoppzeit t₂ festgelegt, wenn eine gemessene Zeitdauer mit gleichem ZC-Signalwert zum übernächsten Mal größer oder gleich dem Zeitdauer-Grenzwert t_{g} ist, wobei die Bewertungsstoppzeit t₂ der Zeitpunkt der folgenden Flanke ist.

Der Timer bzw. Zeitgeber, von dem alle Zeiten abgeleitet werden, läuft nach der Startbedingung frei. Die Zeit, die der Timer für einen Durchlauf benötigt, muß dabei größer sein als das Uberwachungsfenster für das ZC-Signal, welches sich durch eine untere Zeitgrenze Tᵤ und eine obere Zeitgrenze Tₒ definieren läßt.

Werden in diesem Uberwachungsfenster keine weiteren Interrupts detektiert, wird der Meßvorgang abgebrochen und die Meßfunktion wieder in den Grundzustand versetzt (d.h. die Frequenz ist sehr klein).

Das Bestimmen der gesuchten Frequenz f geschieht anhand der gemessenen Zeitdifferenz zwischen der Bewertungsstartzeit t₁ und der Bewertungsstoppzeit t₂, wobei gilt 1/f = t₂ - t₁.

Zur Bestimmung von t_{g} zweckmäßige Parameter sind beispielsweise:

| | |
|---|---|
| Komparatorschwelle ein (Vₒₙ) | 17.5 V |
| Komparatorschwelle aus (V_{off}) | 6.5 V |
| minimale Frequenz (fₘᵢₙ) | 20 Hz |
| maximale Frequenz (fₘₐₓ) | 60 Hz |
| Störspannung (U_{ST}) | 6 V_{S} |
| Rufspannung (U_{R}) | 32 V_{eff} |

Fig. 2 zeigt ein Zustandsdiagramm der Ausführungsform des erfindungsgemäßen Verfahrens nach Fig. 1.

In Fig. 2 bezeichnet I eine Initialisierungsroutine, um in das System in einen Grundzustand G zu versetzen. Ausgehend davon wird das Zeitintervall zwischen den benachbarten steigenden und fallenden Flanken des ZC-Signals gemessen, bis ein Intervall mit t größer gleich t_{g} gefunden ist.

Dann wird der Timer zur einer Bewertungsstartzeit t₁ gestartet (START), welche der Zeitpunkt der folgenden Flanke ist.

Zur Bewertungsstoppzeit t₂, wenn eine gemessene Zeitdauer mit gleichem ZC-Signalwert zum übernächsten Mal größer oder gleich dem Zeitdauer-Grenzwert t_{g} ist, wobei die Bewertungsstoppzeit t₂ der Zeitpunkt der folgenden Flanke ist, wird der Timer wieder gestoppt.

Die verschiedenen Zeitpunkte zu denen eine gemessene Zeitdauer größer oder gleich dem Zeitdauer-Grenzwert t_{g} ist, sind dabei mit I, II und III bezeichnet. Die linke Schleife ist für den Fall einer L-Anfangsphase, die rechte für den Fall einer H-Anfangsphase. Die jeweilige Schleife mit der Bezeichnung 1) bedeutet, daß entweder die Zeit- oder die Phasenbedingung nicht erfüllt ist.

Ist das gemessene Zeitintervall T innerhalb des erlaubten Zeitfensters [Tᵤ,Tₒ], ist die daraus ermittelte Frequenz f gültig, und das System kehrt in den Grundzustand G zurück. Anderenfalls geht das System zurück zum Zustand I.

Obwohl die vorliegende Erfindung vorstehend anhand eines bevorzugten Ausführungsbeispiels beschrieben wurde, ist sie darauf nicht beschränkt, sondern auf vielfältige Weise modifizierbar.

Der Parameter t_{g} kann bei kleinen Messbereichen wie beim obigen Beispiel als Konstante festgelegt werden. Die Zeitintervalle des ungestörten Signalanteils bei höchster gültiger Frequenz fₘₐₓ müssen größer sein als t_{g}. Bei größeren Messbereichen und konstantem ZC-Eingangssignal (d.h. die Frequenz ändert sich nicht während der Messung) kann die Messung mit größtmöglichem t_{g} begonnen werden. Wird keine Startbedingung gefunden, wird der Parameter t_{g} solange verkleinert, bis eine Startbedingung gefunden wird.

## Patentansprüche

1. Tonruf-Frequenzbestimmungsverfahren mit den Schritten:
Bilden eines Zero-Crossing-Signals (ZC) aus dem Tonrufsignal durch Vergleich des Tonrufsignals mit einer Schwelle (S), wobei das ZC-Signal eine Folge von abwechselnd steigenden und fallenden Flanken zwischen zwei ZC-Signalwerten aufweist;
Messen der jeweiligen Zeitdauer zwischen den benachbarten steigenden und fallenden Flanken des ZC-Signals;
Vergleichen der gemessenen Zeitdauern mit einem vorbestimmten Zeitdauer-Grenzwert (t_{g});
Festlegen einer Bewertungsstartzeit (t₁), wenn eine gemessene Zeitdauer größer oder gleich dem Zeitdauer-Grenzwert (t_{g}) ist, wobei die Bewertungsstartzeit (t₁) der Zeitpunkt der folgenden Flanke ist;
Festlegen einer Bewertungsstoppzeit (t₂), wenn eine gemessene Zeitdauer mit gleichem ZC-Signalwert zum übernächsten Mal größer oder gleich dem Zeitdauer-Grenzwert (t_{g}) ist, wobei die Bewertungsstoppzeit (t₂) der Zeitpunkt der folgenden Flanke ist; und
Bestimmen der Frequenz (f) anhand der gemessenen Zeitdifferenz zwischen der Bewertungsstartzeit (t₁) und der Bewertungsstoppzeit (t₂).

2. Tonruf-Frequenzbestimmungsverfahren nach Anspruch 1, **gekennzeichnet durch** die Schritte:
Festlegen eines Überwachungszeitfensters (Tᵤ, Tₒ) für die Frequenzbestimmung; und
Abbrechen der Messung, falls die seit der Bewertungsstartzeit (t₁) gemessene Zeit außerhalb des Überwachungszeitfensters liegt.

3. Tonruf-Frequenzbestimmungsverfahren nach einem der vorhergehenden Ansprüche, **dadurch gekennzeichnet, daß** der Zeitdauer-Grenzwert (t_{g}) als Konstante festgelegt wird.

4. Tonruf-Frequenzbestimmungsverfahren nach einem der Ansprüche 1 oder 2, **dadurch gekennzeichnet, daß** für den Zeitdauer-Grenzwert (t_{g}) eine größtmöglicher Wert festgelegt wird, mit dem der Versuch der Festlegung der Bewertungsstartzeit (t₁) begonnen wird; und dieser Wert nach einem vorbestimmten Algorithmus verkleinert wird, wenn nach einer bestimmten Zeit keine Bewertungsstartzeit (t₁) festlegbar ist.

5. Tonruf-Frequenzbestimmungsvorrichtung mit:
einer ZC-Signalerzeugungseinrichtung zum Bilden eines ZC-Signals aus dem Tonrufsignal durch Vergleich des Tonrufsignals mit einer Schwelle (S), wobei das ZC-Signal eine Folge von abwechselnd steigenden und fallenden Flanken zwischen zwei ZC-Signalwerten aufweist;
einer Meßeinrichtung zum Messen der jeweiligen Zeitdauer zwischen den benachbarten steigenden und fallenden Flanken des ZC-Signals;
einer Vergleichseinrichtung zum Vergleichen der gemessenen Zeitdauern mit einem vorbestimmten Zeitdauer-Grenzwert (t_{g});
einer Festlegungseinrichtung zum Festlegen:
i) einer Bewertungsstartzeit (t₁), wenn eine gemessene Zeitdauer größer oder gleich dem Zeitdauer-Grenzwert (t_{g}) ist, wobei die Bewertungsstartzeit (t₁) der Zeitpunkt der folgenden Flanke ist; und
ii) Festlegen einer Bewertungsstoppzeit (t₂), wenn eine gemessene Zeitdauer mit gleichem ZC-Signalwert zum übernächsten Mal größer oder gleich dem Zeitdauer-Grenzwert (t_{g}) ist, wobei die Bewertungsstoppzeit (t₂) der Zeitpunkt der folgenden Flanke ist;
und einer Frequenzbestimmungseinrichtung zum Bestimmen der Frequenz (f) anhand der gemessenen Zeitdifferenz zwischen der Bewertungsstartzeit (t₁) und der Bewertungsstoppzeit (t₂).

6. Tonruf-Frequenzbestimmungsvorrichtung nach Anspruch 5, **dadurch gekennzeichnet, daß** die Festlegungseinrichtung zum Festlegen eines Überwachungszeitfensters (Tᵤ, Tₒ) für die Frequenzbestimmung und zum Abbrechen der Messung, falls die seit der Bewertungsstartzeit (t₁) gemessene Zeit außerhalb des Überwachungszeitfensters liegt, gestaltet ist.

7. Tonruf-Frequenzbestimmungsvorrichtung nach einem der vorhergehenden Ansprüche 5 oder 6, **dadurch gekennzeichnet, daß** die Festlegungseinrichtung den Zeitdauer-Grenzwert (t_{g}) als Konstante festlegt.

8. Tonruf-Frequenzbestimmungsvorrichtung nach einem der Ansprüche 5 oder 6, **dadurch gekennzeichnet, daß** die Festlegungseinrichtung für den Zeitdauer-Grenzwert (t_{g}) einen größtmöglichen Wert festlegt, mit dem der Versuch der Festlegung der Bewertungsstartzeit (t₁) beginnt; und dieser Wert nach einem vorbestimmten Algorithmus verkleinerbar ist, wenn nach einer bestimmten Zeit keine Bewertungsstartzeit (t₁) festlegbar ist.

## Claims

1. Method for determining tone ringing frequency, with the following steps:
forming a a zero-crossing signal (ZC) from a tone ringing signal by comparing the tone ringing signal with a threshold (S), the ZC signal having a succession of alternately rising and falling edges between two ZC signal values;
measuring the respective time duration between the adjacent rising and falling edges of the ZC signal;
comparing the measured time durations with a predetermined time duration limit value (t_{g}) ;
defining an evaluation start time (t₁) if a measured time duration is greater than or equal to the time duration limit value (t_{g}), the evaluation start time (t₁) being the instant of the subsequent edge;
defining an evaluation stop time (t₂) if a measured time duration with an identical ZC signal value to the next-but-one instance is greater than or equal to the time duration limit value (t_{g}), the evaluation stop time (t₂) being the instant of the subsequent edge; and
determining the frequency (f) on the basis of the measured time difference between the evaluation start time (t₁) and the evaluation stop time (t₂).

2. Method for determining tone ringing frequency according to Claim 1, **characterized by** the following steps:
defining a monitoring time window (Tᵤ, Tₒ) for the frequency determination; and
discontinuing the measurement if the time measured since the evaluation start time (t₁) lies outside the monitoring time window.

3. Method for determining tone ringing frequency according to one of the preceding claims, **characterized in that** the time duration limit value (t_{g}) is defined as a constant.

4. Method for determining tone ringing frequency according to either of Claims 1 and 2, **characterized in that** a value which is as great as possible is defined for the time duration limit value (t_{g}), with which the attempt to define the evaluation start time (t₁) is commenced; and this value is reduced in accordance with a predetermined algorithm if no evaluation start time (t₁) can be defined after a certain time.

5. Device for determining tone ringing frequency, with:
a ZC signal generating means for forming a ZC signal from a tone ringing signal by comparing the tone ringing signal with a threshold (S), the ZC signal having a succession of alternately rising and falling edges between two ZC signal values;
a measuring means for measuring the respective time duration between the adjacent rising and falling edges of the ZC signal;
a comparison means for comparing the measured time durations with a predetermined time duration limit value (t_{g});
a defining means for defining
i) an evaluation start time (t₁) if a measured time duration is greater than or equal to the time duration limit value (t_{g}), the evaluation start time (t₁) being the instant of the subsequent edge;
ii) an evaluation stop time (t₂) if a measured time duration with an identical ZC signal value to the next-but-one instance is greater than or equal to the time duration limit value (t_{g}), the evaluation stop time (t₂) being the instant of the subsequent edge; and
a frequency-determining means for determining the frequency (f) on the basis of the measured time difference between the evaluation start time (t₁) and the evaluation stop time (t₂).

6. Device for determining tone ringing frequency according to Claim 5, **characterized in that** the defining means for defining a monitoring time window (Tᵤ, Tₒ) is designed for the frequency determination and for discontinuing the measurement if the time measured since the evaluation start time (t₁) lies outside the monitoring time window.

7. Device for determining tone ringing frequency according to either of the preceding Claims 5 and 6, **characterized in that** the defining means defines the time duration limit value (t_{g}) as a constant.

8. Device for determining tone ringing frequency according to either of Claims 5 and 6, **characterized in that** the defining means defines a value which is as great as possible for the time duration limit value (t_{g}), with which the attempt to define the evaluation start time (t₁) is commenced; and this value can be reduced in accordance with a predetermined algorithm if no evaluation start time (t₁) can be defined after a certain time.

## Revendications

1. Procédé de détermination de la fréquence d'une tonalité d'appel, comprenant les étapes consistant à :
former un signal de passage par zéro ("Zero-Crossing" - ZC) à partir du signal de tonalité d'appel, par comparaison du signal de tonalité d'appel à un seuil (S), le signal ZC présentant une succession de flancs alternativement montants et descendants entre deux valeurs du signal ZC ;
mesurer chaque durée entre les flancs montants et les flancs descendants voisins du signal ZC ;
comparer les durées mesurées à une valeur limite prédéterminée de durée (t_{g}) ;
déterminer un instant de début d'évaluation (t₁) lorsqu'une durée mesurée est supérieure ou égale à la valeur limite de durée (t_{g}), l'instant de début d'évaluation (t₁) étant l'instant de l'apparition du flanc suivant ;
déterminer un instant d'arrêt d'évaluation (t₂) lorsqu'une durée mesurée présentant la même valeur du signal ZC est pour la deuxième fois supérieure ou égale à la valeur limite de durée (t_{g}),
l'instant d'arrêt d'évaluation (t₂) étant l'instant de l'apparition du flanc suivant ; et
déterminer une fréquence (f) à l'aide de la différence de temps mesuré entre l'instant de début d'évaluation (t₁) et l'instant d'arrêt d'évaluation (t₂).

2. Procédé de détermination de la fréquence d'une tonalité d'appel selon la revendication 1, **caractérisé par** les étapes consistant à :
déterminer une fenêtre temporelle de surveillance (Tᵤ, Tₒ) pour la détermination de la fréquence ; et
interrompre la mesure au cas où la durée mesurée depuis l'instant de début d'évaluation (t₁) s'étend au-delà de la fenêtre temporelle de surveillance.

3. Procédé de détermination de la fréquence d'une tonalité d'appel selon l'une des revendications précédentes, **caractérisé en ce que** la valeur limite de durée (t_{g}) est définie comme constante.

4. Procédé de détermination de la fréquence d'une tonalité d'appel selon l'une des revendications 1 ou 2, **caractérisé en ce que** pour la valeur limite de durée (t_{g}), on définit une valeur aussi grande que possible avec laquelle on commence à tenter de déterminer l'instant de début d'évaluation (t₁), cette valeur étant diminuée selon un algorithme prédéterminé lorsqu'après une durée définie, on n'a pas pu définir un instant de début d'évaluation (t₁).

5. Dispositif de détermination de la fréquence d'une tonalité d'appel, comprenant :
un dispositif de création d'un signal ZC pour la formation d'un signal ZC à partir du signal de tonalité d'appel, par comparaison du signal de tonalité d'appel à un seuil (S), le signal ZC présentant une succession de flancs alternativement montants et descendants entre deux valeurs du signal ZC ;
un dispositif de mesure pour la mesure de chaque durée qui s'écoute entre les flancs montants et les flancs descendants voisins du signal ZC ;
un dispositif de comparaison pour comparer des durées mesurées à une valeur limite prédéterminée de durée (t_{g}) ;
un dispositif de détermination, pour déterminer :
i) un instant de début d'évaluation (t₁) lorsqu'une durée mesurée est supérieure ou égale à la valeur limite de durée (t_{g}), l'instant de début d'évaluation (t₁) étant l'instant de l'apparition du flanc suivant ; et
ii) un instant d'arrêt d'évaluation (t₂) lorsqu'une durée mesurée présentant la même valeur du signal ZC est pour la deuxième fois supérieure ou égale à la valeur limite de durée (t_{g}), l'instant d'arrêt d'évaluation (t₂) étant l'instant de l'apparition du flanc suivant ;
et un dispositif de détermination de fréquence pour la détermination de la fréquence (f) à l'aide de la différence de temps mesurée entre l'instant de début d'évaluation (t₁) et l'instant de fin d'évaluation (t₂).

6. Dispositif de détermination de la fréquence d'une tonalité d'appel selon la revendication 5, **caractérisé en ce que** le dispositif de détermination est configuré pour déterminer une fenêtre temporelle de surveillance (Tᵤ, Tₒ) pour la détermination de la fréquence et pour l'interruption de la mesure au cas où le temps mesuré depuis l'instant de début d'évaluation (t₁) s'étend au-delà de la fenêtre temporelle de surveillance.

7. Dispositif de détermination de la fréquence d'une tonalité d'appel selon l'une des revendications précédentes 5 ou 6, **caractérisé en ce que** le dispositif de détermination détermina la valeur limite de durée (t_{g}) en tant que constante.

8. Dispositif de détermination de la fréquence d'une tonalité d'appel selon l'une des revendications 5 ou 6, **caractérisé en ce que** le dispositif de définition de la valeur limite de durée (t_{g}) définit une valeur aussi grande que possible avec laquelle commence la tentative de détermination de l'instant de début d'évaluation (t₁), cette valeur pouvant être diminuée selon un algorithme prédéterminé lorsqu'après une durée définie aucun instant de début d'évaluation (t₁) n'a pu être défini.
